Europäisches Patentamt

European Patent Office

Office européen des brevets

(19)

(11) Publication number: **0 262 034 B1**

(12) **EUROPEAN PATENT SPECIFICATION**

(45) Date of publication of patent specification: **17.06.92** (51) Int. Cl.5: **H01L 21/225**

(21) Application number: **87402081.1**

(22) Date of filing: **17.09.87**

(54) Impurity doping method for the fabrication of semiconductor devices.

(30) Priority: **20.09.86 JP 220919/86**

(43) Date of publication of application:
**30.03.88 Bulletin 88/13**

(45) Publication of the grant of the patent:
**17.06.92 Bulletin 92/25**

(84) Designated Contracting States:
**DE FR GB**

(56) References cited:
**US-A- 3 532 563**
**US-A- 4 521 441**
**US-A- 4 565 588**

**JOURNAL OF THE ELECTROCHEMICAL SOCI-
ETY, vol. 129, no. 11, November 1982, pages
2537-2541, Manchester, New Hampshire, US;
S. DZIOBA et al.: "Decapsulation and
photoresist stripping in oxygen microwave
plasmas"**

(73) Proprietor: **FUJITSU LIMITED**
**1015, Kamikodanaka Nakahara-ku**
**Kawasaki-shi Kanagawa 211(JP)**

(72) Inventor: **Fujimura, Shuzo**
**1-4-6-401, Kitakoiwa Edogawa-ku**
**Tokyo 133(FR)**

(74) Representative: **Joly, Jean-Jacques et al**
**CABINET BEAU DE LOMENIE 55, rue
d'Amsterdam**
**F-75008 Paris(FR)**

# Description

The present invention relates to the manufacture of semiconductor devices and more particularly to a novel impurity doping method which enables formation of shallow pn junctions that are required for submicron semiconductor devices.

As a result of recent developments in high packing density semiconductor integrated circuits (ICs), micro-miniaturization of semiconductor devices, which are the elements of such ICs, has greatly progressed toward reducing the size of MOSFET elements (Metal-Oxide-Semiconductor Field Effect Transistor). For example, gate lengths of 500nm (0.5 micron) or less have been experimentally manufactured.

Such submicron semiconductor devices require shallow pn junctions. For example, a MOSFET scaled down to have a gate length of 500 nm (0.5 micron) or less requires a shallow pn junction having a depth of 100 nm (0.1 micron) or less. Of several impurity doping methods proposed to form pn junctions, ion implantation is the most widely employed method for manufacturing high density ICs.

Ion implantation is superior to the other impurity doping methods because the impurity doping depth, namely the depth of the pn junction, and the impurity doping concentration can be independently controlled by changing ion acceleration energy and accummulated ion current, respectively. In order to form shallow pn junctions using ion implantation, the impurity doping depth must be shallow, and the diffusion of the impurity must be minimized during the thermal processing used to activate the impurity. In view of these requirements, the following procedures are used. Namely ion acceleration energy is set to 10 keV or less in order to provide a shallow impurity doping depth. Also, the impurity is implanted through an amorphous layer such as $SiO_2$ or amorphous silicon in order to eliminate the channeling effect which becomes distinctive when the acceleration energy is lowered; and rapid thermal annealing (RTA) or annealing at a low temperature, such as 800°C or less, is carried out in order to minimize the diffusion of the impurity during the thermal processing. Such procedures are discussed in M. Delfino, D.K. Sanada, and A.E.Morgan, "Shallow junction formation by preamorphization with tin implantation", Appl.Phys. Lett. 49, 575-577, (1986); and I.W. Wu, R.T.Fulks, and J.C. Mikkelsen, Jr. "Optimization of $BF_2^+$ implanted and rapidly annealed junctions in silicon", J. Appl.Phys. 60, 2422-2438, (1986).

However, if ion acceleration energy is lowered in a conventional ion implantation apparatus, the ion beam becomes difficult to converge due to repulsion of ions; it also becomes difficult to extract the necessary ion current. Therefore, lowering acceleration energy in ion implantation is not desirable for reasons such as these.

Ion implantation always damages the surface of a semiconductor substrate because of the ion bombardment. Usually, the surface of the semiconductor substrate is amorphized and many defects are introduced into the semiconductor substrate as a result of ion implantation. During thermal processing to activate the impurity, abnormal diffusion of the impurity can occur at the locations of the introduced defects. This is a serious impediment to forming shallow pn junctions by ion implantation.

Impurity doping, using plasma which assures lower energy ions, is also proposed as a method of forming shallow pn junctions. Impurity doping by exposing a semiconductor substrate to a gas plasma containing impurity species is used in fabricating IC devices. In this method radio frequency (RF) or microwave power is used to generate the plasma such as described in M. Itoga, "Method to Form Impurity Doped Layer", Japanese Laid-Open Patent (A) No. 138921/1981; or a DC discharge such as described in M.Yabe, Y.Seki, and N.Sato; "Impurity to crystalline silicon and amorphous film and formation of boron film at low temperatures using DC plasma process", Surface Process Investigation, 2, 147-153, (1983).

The plasma method, however, has a disadvantage that the surface of the semiconductor substrate cannot be free from damage due to ion bombardment because the semiconductor substrate is exposed directly to the plasma, even though the energy of ions in the plasma is lower than that of ions in ion implantation.

In another plasma method, the surface of semiconductor substrate is coated with a liquid in which a material containing desired impurity atoms (e.g. phosphoric acid or boric acid) are dissolved. After coating with such a liquid, the liquid on the surface is dried, and the surface is exposed to an inactive gas plasma so as to introduce the impurity into semiconductor substrate such as discussed in N. Sato, "Impurity diffusing method", Japanese Laid-Open Patent (A) No. 153119/1985. In this method, however, the surface of the semiconductor substrate can also be damaged in some cases. This occurs when the material containing the impurity forms only a thin coat on the substrate. In addition, the unnecessary impurity containing material must be removed after introducing the impurity into the substrate.

The above described methods require, in the case of selective doping, the process of removing a mask after the formation of the mask and the introduction of the impurity into the substrate.

Finally, there is disclosed in document US-A-4 521 441 a semiconductor doping process in which a spin-on dopant material is applied and treated in an oxygen plasma after which the substrate and dopant material are heated to an elevated temperature to accomplish the desired depth of diffusion.

## SUMMARY OF THE INVENTION

It is an object of the present invention to provide an improved impurity doping method.

It is another object of the present invention to provide an improved method of forming shallow pn junctions which is suitable for manufacturing high packing density IC's.

It is another object of the present invention to provide a simplified impurity doping method for selectively forming pn junctions.

These objects can be attained by an impurity doping method for the fabrication of semiconductor devices, comprising the successive steps of : (a) forming an impurity containing resist layer on a semiconductor substrate; (b) placing the substrate in a chamber; (c) exposing the substrate to an oxygen-containing plasma both to remove the resist layer and to introduce the impurity into the substrate by plasma energy. A plasma is used which contains oxygen, and the resist layer is removed by being decomposed.

One advantage of the method of the present invention results in shallower pn junctions compared to those obtained by ion implantation. In addition, the method of the present invention minimizes damage to the semiconductor substrate.

Another advantage of the method of the present invention is the simultaneous removal of the resist layer and the introduction of the impurity into the substrate by the plasma energy.

The method of the present invention, therefore, greatly simplifies the selective impurity doping process.

Because of the simplified processing steps of the present invention, the apparatus needs only generate a plasma. The apparatus structure is therefore simplified and less costly.

## BRIEF DESCRIPTION OF THE DRAWINGS

Fig.1 is a schematic sectional view of a plasma generating apparatus used in carrying out a method according to an embodiment of the present invention,

Figs. 2(a)-2(e) schematically illustrate the process steps of an embodiment of the present invention.

## DETAILED DESCRIPTION OF PARTICULAR EMBODIMENTS

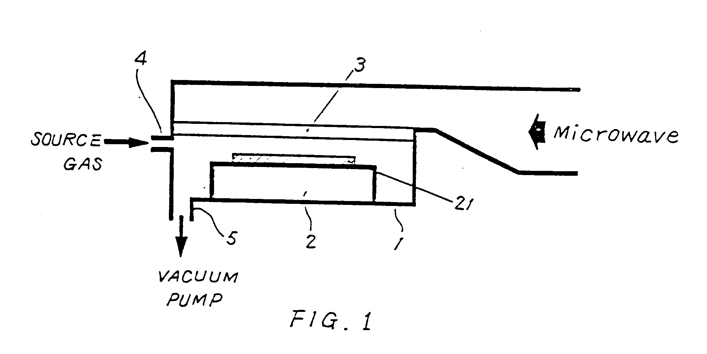

A plasma generating apparatus used for plasma processing in an embodiment of the present invention is schematically illustrated in Fig.1. A chamber 1 forms a microwave cavity and houses a stage 2 on which a semiconductor substrate 21 that is to be processed by plasma is set. A quartz window 3 is attached at a location opposite the stage 2. Microwaves are irradiated through the window 3 in order to excite the plasma. The stage 2 may also be cooled by water so as to reduce the temperature rise of the semiconductor substrate loaded thereon. The chamber 1 is also provided with a gas supply port 4 to supply a source gas used in generating the plasma, and an exhaust port 5 to be connected with a vacuum pump for evacuating the chamber 1.

After setting a semiconductor substrate 21 on the stage 2 of this apparatus, the chamber 1 is evacuated, a gas such as oxygen ($O_2$) or a gas mixture of oxygen and an inactive gas such as argon (Ar) is supplied to the chamber 1 through the gas supply port 4. Pressure within the chamber is maintained at about 13 to 130 Pa (0.1 to 1 Torr) and microwave power at a frequency of, for example, 2.45 GHz is introduced through the quartz window 3. Thereby, a plasma containing oxygen is generated in the chamber 1 and the surface of the semiconductor substrate 21 is exposed to the plasma. The plasma generating apparatus is not limited to the microwave excited plasma generating apparatus as shown in Fig.1 and it can be replaced with a radio frequency (RF) or ultra high frequency (UHF) excited plasma generating apparatus or a DC discharge plasma generating apparatus.

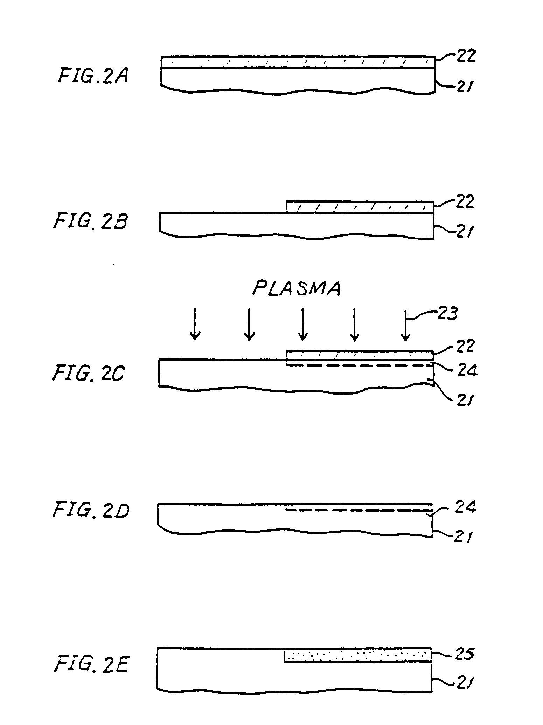

A first embodiment wherein phosphorus (P) is doped in a silicon substrate using the plasma generating apparatus shown in Fig.1 will be explained hereunder with reference to Figs. 2A-2E.

A resist containing phosphorus (P) is prepared by dissolving 0.7g of phosphorus pentaoxide ($P_2O_5$) in 100cc of 2-methoxyethanol and mixing it with 200cc of the commercially available novolac resist Tokyo-ohka TSMR8800, manufactured by Tokyo-ohka Ltd., 1-403, Kosugi-chyo, Nakahara-ku, Kawasaki-shi, Kanagawa, Japan. The amount of resist and the amount and type of materials to be added thereto can be changed as required, but for practical use it is desirable not to change the basic characteristics of the resist. For example, when P doping, it is preferable to have a concentration of less than 4mg of P (pure) per 1cc of resist mixture. In addition, $H_3PO_4$ can be used instead of $P_2O_5$, and Tokyo-ohka OEBR 1000 can be used instead of 15MR8800. When doping with boron (B), it is preferable to have a concentration of less than 2.3mg of B (pure) per 1cc of resist mixture.

The semiconductor substrate can comprise a boron doped p-type silicon (Si) substrate with (100) orientation and a resistivity of 11 to 15 ohms-cm.

The resist is placed on the surface of the silicon substrate 21 which is spun on a conventional spinner at a rate of 6000 rpm for approximately 1 minute. About 2cc of resist is used to coat a 4 inch wafer. Thereby, a resist layer 22 is formed (Fig. 2A) having a thickness of about 500 nm. The substrate is then baked at 150°C for 30 minutes in a nitrogen atmosphere in order to vaporize the organic solvent in the resist layer. Thereafter, the resist layer is patterned by, for example, photolithography.

Next, the semiconductor substrate 21 is exposed to an oxygen plasma 23 as indicated in Fig. 2C. In a preferred embodiment of the present invention, the conditions for plasma processing are as follows. The microwave frequency is 2.45 GHz, the microwave power is 1.5 kW, the flow rate of oxygen gas is 250 sccm, the pressure is 65 Pa (0.5 Torr), the substrate temperature is about 250°C, and the processing time is 10 minutes.

When the substrate is exposed to the oxygen plasma, the resist layer 22 is oxidized. This oxidation reduces its thickness. Exposure to the oxygen plasma also causes the phosphorus P in the resist layer 22 to be introduced into the silicon substrate forming a P-doped layer 24 as shown in Fig. 2C. The portion of the substrate 21 not covered by the resist 22 is oxidized, forming a $SiO_2$ film (not illustrated) on this portion of substrate surface.

Continued exposure to the oxygen plasma reduces the thickness of the resist layer 22 so that it is removed, leaving the P-doped layer 24 selectively formed in a part of the substrate that was underneath resist layer 22 (Fig. 2D). Thus, continuing exposure to the oxygen plasma simultaneously removes the resist layer 22 and forms doped region 24.

After plasma processing, the substrate is immersed in a solution of hydrogen peroxide ($H_2O_2$) and sulfuric acid ($H_2SO_4$), these components being mixed with a ratio of 2 : 100. This removes organic materials still remaining at the surface of the substrate. Then, the $SiO_2$ film formed on the surface of the semiconductor substrate 21 is removed with the fluoric acid (HF) solution. The substrate is then rinsed in water and dried. The substrate is then annealed at 800°C for 30 minutes in a nitrogen atmosphere. The annealing process activates the phosphorus in the region 24 to form an impurity diffused layer 25 (Fig. 2E). The annealing process can also be performed with or without the $SiO_2$ film removed.

The layer 25 formed per the above is an n-type layer and has a typical sheet resistance (measured using a four point probe) of 600 ohms/square. The portion of the substrate that was not covered with the resist layer is p-type with a sheet resistance of 200 ohms/square. These measurements show that phosphorus, which is an n-type impurity, is diffused into the silicon substrate simultaneously with the removal of the resist layer as a result of exposing the substrate to oxygen plasma in accordance with the method of the present invention.

Measurement of the sheet resistance indicates the depth of the pn junction formed by the method of the present invention. The measurement, using a four point probe showed a significant increase in resistance after the substrate was etched about 20 nm from the surface. This result shows that the pn junction in accordance with the method of the present invention is at least as shallow as 20 nm (0.02 micron). To perform the above etching, a $SiO_2$ film is first formed on the Si substrate surface using a solution of $H_2O_2$ and $H_2SO_4$ with a ratio of 2 : 100. Then a solution such as fluoric acid (HF) is used to selectively etch the $SiO_2$ film on the substrate.

Doping the substrate using boron, which is a p-type impurity, will now be explained as a second embodiment of the present invention.

A resist containing boron is prepared by mixing 1.3g of Boric acid ($H_3BO_3$) with 50cc of 2-methoxyethanol. This solution is mixed with 50cc of commercially available novolac resist Tokyo-ohka TSMR 8800. An n-type silicon substrate with (100) orientation and a resistivity of 15 to 20 ohms-cm is used as the substrate 21.

The process steps, from coating the substrate 21 with the resist through activation of the impurity to form the impurity diffused layer 25 by thermal processing after plasma processing, are carried out under the same conditions as those discussed with respect to the first embodiment.

In the second embodiment, a p-type diffused layer 25 having a sheet resistance of 3 ohms/square is formed. The portion of the substrate 21 that was not covered by resist 22 is n-type and has a sheet resistance of 200 ohms/square. These measurements show that boron, which is a p-type impurity is diffused into the silicon substrate simultaneously with the removal of the resist layer as a result of exposing the substrate to the oxygen plasma.

In the above description, phosphorus and boron are doped into the silicon substrate, but it is also possible to use other elements, such as As as impurity. The present invention can also be employed as impurity doping method for semiconductors other than Si, for example, III-V compound semiconductors such as GaAs and InP. When the substrate is GaAs or InP, a resist including a p-type impurity such as zinc (Zn) and cadmium (Cd), or a resist including a n-type impurity such as tin (Sn), sulfur (S), selenium (Se) and tellurium (Te), can be used.

In the above-described embodiments, oxygen gas plasma is used, but any type of plasma including oxygen may be used to decompose the organic resist. For example, a mixed gas plasma of oxygen (or oxygen compound) and nitrogen gas or a rare gas may also be used.

As is obvious from the above explanation, the present invention is easily capable of forming shallow pn junctions which are required to manufacture high packing density IC's. In the method of the present invention, the resist layer functions both as an impurity source and as a mask for selective doping of the semiconductor substrate. In the present invention, removal of the resist occurs simultaneously with the process of selective doping of the substrate. Since the process for removing the mask, which was required by previous methods is no longer necessary, the manufacturing process is greatly simplified.

## Claims

1. An impurity doping method for the fabrication of semiconductor devices, comprising the successive steps of :
    a) forming an impurity-containing resist layer (22) on a semiconductor substrate (21);
    b) placing the substrate in a chamber (1);
    c) exposing the substrate to an oxygen-containing plasma both to remove the resist layer and to introduce the impurity into the substrate.

2. A method according to claim 1, characterized in that it further includes the sub-step of heating the substrate (21) during step c).

3. A method according to claim 2, characterized in that it further comprises the step of annealing the substrate (21) after step c).

4. A method according to any one of claims 1 to 3, characterized in that step b) includes the sub-step of evacuating the chamber (1) after the substrate (21) has been placed in the chamber.

## Revendications

1. Procédé de dopage par impureté pour la fabrication de dispositifs semi-conducteurs, comprenant les étapes successives de :
    a) formation d'une couche de resist (22) contenant l'impureté sur un substrat semi-conducteur (21) ;
    b) introduction du substrat dans une chambre (1) ;
    c) exposition du substrat à un plasma contenant de l'oxygène pour à la fois retirer la couche de resist et introduire l'impureté dans le substrat.

2. Procédé selon la revendication 1, caractérisé en ce qu'il comprend en outre l'opération de chauffage du substrat (21) durant l'étape c).

3. Procédé selon la revendication 2, caractérisé en ce qu'il comprend en outre l'étape de recuit du substrat (21) après l'étape c).

4. Procédé seton l'une quetconque des revendications 1 à 3, caractérisé en ce que l'étape b) comprend l'opération de réalisation du vide dans ta chambre (1) après l'introduction du substrat (21) dans la chambre.

## Patentansprüche

1. Verunreinigungs-Dotierungsverfahren zur Herstellung von Halbleitervorrichtungen, mit den folgenden Schritten:
    a) Bilden einer Verunreinigungen enthaltenden Widerstandsschicht (22) auf einem Halbleitersubstrat (21);
    b) Plazieren des Substrates in eine Kammer (1);
    c) Exponieren des Substrates einem sauerstoffhaltigen Plasma, sowohl zum Entfernen der Resistschicht als auch zur Einführung der Verunreinigung in das Substrat.

2. Verfahren nach Anspruch 1, dadurch gekennzeichnet, daß es ferner den Unter-Schritt des Erhitzens des Substrates (21) während des Schhrittes c) umfaßt.

3. Verfahren nach Anspruch 2, dadurch gekennzeichnet, daß es ferner den Schritt der Annealbehandlung des Substrates (21) nach dem Schritt c) umfaßt.

4. Verfahren nach einem der Ansprüche 1 bis 3, dadurch gekennzeichnet, daß der Schritt c) den Unter-Schritt der Evakuierung der Kammer (1), nachdem das Substrat (21) in die Kammer plaziert worden ist, umfaßt.

FIG. 1

FIG.2A

22
21

FIG.2B

22
21

PLASMA

↓ ↓ ↓ ↓ ↓ —23

FIG.2C

22
24
21

FIG.2D

24
21

FIG.2E

25
21